Europäisches Patentamt

European Patent Office

Office européen des brevets

(19)

(11) Veröffentlichungsnummer: **0 208 970**
**B1**

(12)

# EUROPÄISCHE PATENTSCHRIFT

(45) Veröffentlichungstag der Patentschrift:
23.05.90

(21) Anmeldenummer: 86108766.6

(22) Anmeldetag: 27.06.86

(51) Int. Cl.⁵: **H01L 25/18, H01L 23/34**

(54) MOSFET mit Temperaturschutz.

(30) Priorität: 09.07.85 DE 3524517

(43) Veröffentlichungstag der Anmeldung:
21.01.87 Patentblatt 87/4

(45) Bekanntmachung des Hinweises auf die Patenterteilung:
23.05.90 Patentblatt 90/21

(84) Benannte Vertragsstaaten:
CH DE FR GB IT LI SE

(56) Entgegenhaltungen:
EP-A- 0 144 978
FR-A- 2 245 089
GB-A- 1 021 206
US-A- 4 050 083
US-A- 4 117 505

PATENTS ABSTRACTS OF JAPAN, Band 1, Nr. 163, 22.
Dezember 1977, Seite 9163 E 77; &
JP-A-52 109 881 (MITSUBISHI DENKI K.K.) 14-09-1977
PATENTS ABSTRACTS OF JAPAN, Band 9,
Nr. 65 (E-304)[1788], 26. März 1985; &
JP-A-59 202 658 (HITACHI SEISAKUSHO
K.K.) 16-11-1984

(73) Patentinhaber: Siemens Aktiengesellschaft,
Wittelsbacherplatz 2, D-8000 München 2(DE)

(72) Erfinder: Tihanyi, Jenö, Dr.-Ing., Windeck 1d,
D-8000 München 70(DE)
Erfinder: Bierlmaier, Johann, Rimstingerstrasse 2,
D-8000 München 80(DE)

**Beschreibung**

Halbleiterbauelemente sind nur bis zu bestimmten Temperaturen funktionsfähig. Übersteigen die Junction-Temperaturen Werte, die je nach Aufbau des Halbleiterbauelements zwischen 130 und 180 °C liegen, so verlieren sie ihre Sperrfähigkeit. Der Stromfluß durch das Halbleiterbauelement kann dabei so groß werden, daß das Bauelement zerstört wird. Hohe Außentemperaturen können dazu führen, daß das Halbleiterbauelement bereits unterhalb seines Nennstroms nicht mehr sperrfähig ist. Diese Probleme treten bei allen Halbleiterbauelementen mit pn-Übergang auf, d. h. sowohl bei bipolaren Halbleiterbauelementen als auch bei IGFET-Strukturen. Aus US-A 4 050 083 ist es bekannt, ein Halbleiterbauelement mittels eines im Halbleiterkörper integrierten temperaturempfindlichen Thyristors gegen hohe Temperaturen zu schützen.

Die Erfindung bezieht sich auf ein Halbleiterbauelement, enthaltend einen MOSFET, der einen Halbleiterkörper mit zwei Hauptflächen sowie eine Gateelektrode und eine Sourceelektrode aufweist.

Der Erfindung liegt die Aufgabe zugrunde, einen solchen MOSFET so auszubilden, daß er zuverlässig gegen hohe Temperaturen geschützt ist.

Diese Aufgabe wird gelöst durch die Merkmale:

a) Auf einer der Hauptflächen des Halbleiterkörpers des MOSFET ist der Halbleiterkörper eines Halbleiterschalters mit p-n-Übergang befestigt, der bei Erreichen einer bestimmten Temperatur seines p-n-Überganges einschaltet,

b) beide Halbleiterkörper sind thermisch miteinander verbunden,

c) der Halbleiterkörper des Halbleiterschalters hat zwei Hauptelektroden,

d) die Hauptelektroden sind mit der Gateelektrode bzw. mit der Sourceelektrode verbunden.

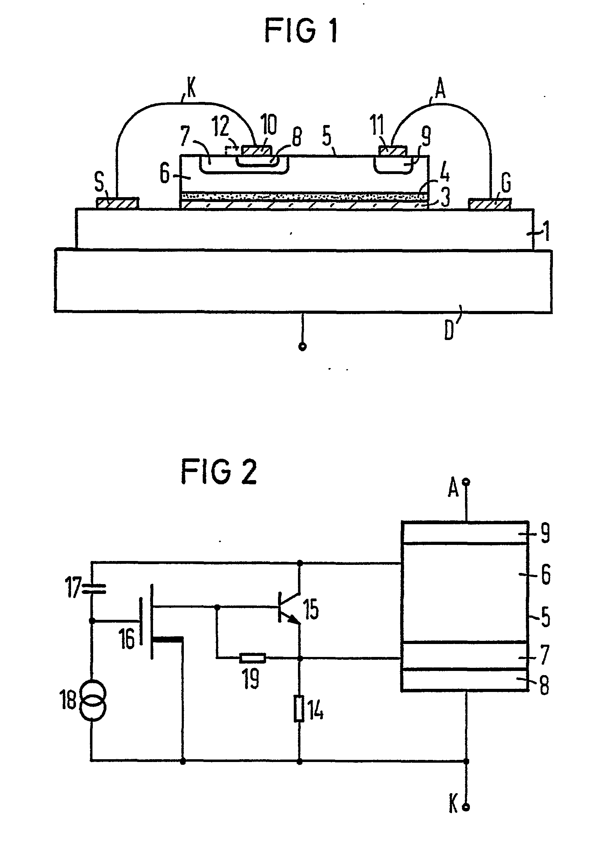

Weiterbildungen der Erfindung sind Gegenstand der Unteransprüche. Die Erfindung wird anhand von Ausführungsbeispielen in Verbindung mit den Fig. 1 und 2 näher erläutert. Es zeigen:

Fig. 1 den Schnitt durch ein einfaches Ausführungsbeipiel und

Fig. 2 eine einfache, vorzugsweise integrierbare Schaltungsanordnung für den Halbleiterschalter mit gegenüber der Anordnung nach Fig. 1 verbesserten Eigenschaften.

Das Halbleiterbauelement nach Fig. 1 weist einen MOSFET auf, dessen Halbleiterkörper vereinfacht dargestellt und mit 1 bezeichnet ist. Eine der Hauptflächen des Halbleiterkörpers 1 ist mit einer Drainelektrode D verbunden. Auf der anderen Hauptfläche sitzt eine Sourceelektrode S und eine Gateelektrode G. Auf der gleichen Hauptfläche wie die Source- und die Gateelektrode sitzt ein Halbleiterschalter, dessen Halbleiterkörper mit 5 bezeichnet ist. Dieser Halbleiterschalter kann wie gezeigt im einfachsten Falle ein lateral aufgebauter Thyristor sein. Er besteht aus einer Mittelzone 6, in die eine anodenseitige Emitterzone 9 und eine katodenseitige Basiszone 7 planar eingebettet sind. In die Zone 7 ist eine katodenseitige Emitterzone 8 planar eingebettet. Die Zonen 8, 9 sind mit Elektroden 10 bzw. 11 versehen, die den Katodenanschluß K bzw. den Anodenanschluß A bilden. Die Elektroden 10, 11 sind elektrisch mit der Sourceelektrode S bzw. mit der Gateelektrode G verbunden.

Der Thyristor ist zweckmäßigerweise elektrisch gegen den Halbleiterkörper 1 des MOSFET isoliert. Dazu dient eine dünne Isolierschicht 3, die beispielsweise aus Siliciumnitrid $Si_3N_4$ besteht. Der Thyristor kann auf der Isolierschicht 3 durch eine dünne Kleberschicht 4 befestigt sein. Die Schichten 3 und 4 sind so dünn, z. B. 0,5 µm bzw. 5 bis 10 µm, so daß der Thyristor in gutem Wärmekontakt mit dem MOSFET 1 steht.

Wird der MOSFET durch Anlegen einer Spannung zwischen den Elektroden S und D von einem Strom durchflossen, so erwärmt sich der Halbleiterkörper 1 des MOSFET und mit ihm der Thyristor 5. Dabei bildet die Gate-Sourcespannung des MOSFET die Anoden-Katodenspannung für den Thyristor. Steigt die Temperatur im Inneren des MOSFET durch Überlastung oder hoher Umgebungstemperatur an, so steigt die Temperatur des Lateralthyristors 5 ebenfalls an. Damit steigt der Sperrstrom des Thyristors so lange an, bis er zündet. Er bildet einen niederohmigen Stromweg zwischen Anode A und Katode K, so daß die Spannung zwischen Sourceanschluß S und Gateanschluß G des MOSFET praktisch zusammenbricht. Der Durchlaßwiderstand des Thyristors muß dabei im eingeschalteten Zustand kleiner als die Einsatzspannung $U_T$ des MOSFET sein. Dann wird die Gate-Sourcekapazität $C_{GS}$ des MOSFET entladen und dieser wird gesperrt.

Diejenige Temperatur, bei der der Thyristor zündet, kann bei gegebenen Abmessungen und Dotierungen beispielsweise durch einen Nebenschluß 12 zwischen katodenseitiger Emitterzone 8 und katodenseitiger Basiszone 7 eingestellt werden. Der Thyristor kann beispielsweise folgende Dotierungen haben:

Zonen 8, 9: $10^{19}$ bis $10^{20}$ Atome As $cm^{-3}$
Zone 7: $10^{17}$ bis $10^{18}$ Atome B $cm^{-3}$
Zone 6: $10^{14}$ bis $10^{16}$ Atome P $cm^{-3}$

Wird das Halbleiterbauelement in Schaltungen mit hohen du/dt-Belastungen eingesetzt, so kann es vorkommen, daß der Thyristor bereits aufgrund dieser Belastungen gezündet wird, ohne daß eine für den MOSFET kritische Temperatur erreicht ist. Das du/dt-Verhalten des Thyristors kann in bekannter Weise durch Vergrößerung des Nebenschlusses 12 verbessert werden. Damit verringert sich aber die Empfindlichkeit des Thyristors gegen steigende Temperaturen. Es empfiehlt sich daher, für den Halbleiterschalter eine Anordnung zu wählen, die in Fig. 2 dargestellt ist. Sie vereinigt Unempfindlichkeit gegenüber du/dt-Belastungen mit guter Temperaturempfindlichkeit.

Der in Fig. 1 verwendete Thyristor 5 ist in Fig. 2 schematisch dargestellt. Gleiche oder funktionsgleiche Teile wie in Fig. 1 sind mit gleichen Bezugszeichen bezeichnet. Zur Erhöhung der du/dt-Festigkeit ist zwischen den Zonen 7 und 8 ein Widerstand 14 angeordnet, der elektrisch dem Nebenschluß 12 nach Fig. 1 entspricht. Zwischen den Zonen 6 und 7 ist die Basis-Kollektorstrecke eines Transistors 15 angeschlossen. Der Basisanschluß des Transistors 15 ist über die Drain-Sourcestrecke eines MOSFET 16 vom Anreicherungstyp mit dem Katodenanschluß K des Thyristors verbunden. Der Gateanschluß des MOSFET 16 ist einerseits über einen Kondensator 17 mit der anodenseitigen Innenzone 6 des Thyristors und andererseits über eine Stromquelle 18 mit dem Katodenanschluß K des Thyristors verbunden. Zwischen dem Basisanschluß des Fototransistors 15 und seinem Emitteranschluß kann noch ein Widerstand 19 liegen, der der Erhöhung der Emitter-Kollektor-Sperrspannung dient.

Wird der Thyristor über seine beiden Klemmen A, K an die Gate-Sourcespannung des FET 1 gelegt, so fließt durch die Zonen 9, 6, den Kondensator 17, die Stromquelle 18 ein konstanter Strom zum Katodenanschluß des Thyristors. Dieser Strom reicht nicht aus, um den MOSFET 16 einzuschalten.

Bei ansteigender Temperatur des MOSFET erhöht sich auch die Temperatur des Thyristors 5 und des Transistors 15 sowie der anderen Teile der vorzugsweise in integrierter Form aufgebauten Schaltung. Der Thyristor 5 kann aber von sich aus nicht einschalten, da der Widerstand 14 einen starken Nebenschluß bildet. Hingegen steigt der Strom des Transistors 15 mit steigender Temperatur stark an, so daß nun ein Strom von der Anode A, die Zonen 9, 6 durch die Kollektor-Emitterstrecke des Transistors 15, die Zonen 7, 8 zur Katode K fließt. Bei Erreichen einer für den MOSFET 1 kritischen Temperatur reicht dieser Strom zum Zünden des Thyristors 5 aus, er wird eingeschaltet und schließt die Gate-Sourcekapazität $C_{GS}$ des MOSFET 1 kurz.

Tritt hingegen bei einer für den MOSFET 1 unkritischen Temperatur zwischen den Anschlüssen A und K eine steile Spannungsflanke auf, so fließt ein steil ansteigender Strom durch den Kondensator 17 in den Gateanschluß des MOSFET 16, da der Strom durch die Stromquelle 18 konstant bleibt. Der MOSFET 16 wird eingeschaltet und leitet den Basisstrom des Fototransistors 15 ab. Dieser kann daher nichtleitend gesteuert werden und der Thyristor 5 bleibt gesperrt.

Die gesamte Anordnung nach Fig. 2 kann in integrierter Form auf ein Chip 1 x 1 bis 1 x 2 mm Fläche aufgebaut werden. Wegen weiterer Einzelheiten der integrierten Schaltung nach Fig. 2 wird auf die DE-OS 33 44 435 verwiesen, in der die integrierte Schaltung für einen anderen Verwendungszweck beschrieben ist.

Für den Thyristor gilt auch hier, wie bereits in Verbindung mit Fig. 1 erwähnt, daß seine Durchlaßspannung kleiner sein muß als die Einsatzspannung $U_T$ des MOSFET. Für Fälle von MOSFET mit hohen Einsatzspannungen in der Größenordnung einiger Volt kann es auch ausreichen, wenn als Halbleiterschalter statt des Thyristors ein Bipolartransistor verwendet wird.

**Patentansprüche**

1. Halbleiterbauelement, enthaltend einen MOSFET, der einen Halbleiterkörper mit zwei Hauptflächen sowie eine Gateelektrode und eine Sourceelektrode aufweist, **gekennzeichnet** durch die Merkmale:
   a) Auf einer der Hauptflächen des Halbleiterkörpers (1) des MOSFET ist der Halbleiterkörper eines Halbleiterschalters (5) mit p-n-Übergang befestigt, der bei Erreichen einer bestimmten Temperatur seines p-n-Überganges einschaltet,
   b) beide Halbleiterkörper (1, 5) sind thermisch miteinander verbunden,
   c) der Halbleiterkörper des Halbleiterschalters (5) hat zwei Hauptelektroden (10, 11),
   d) die Hauptelektroden sind mit der Gateelektrode (G) bzw. mit der Sourceelektrode (S) verbunden.

2. Halbleiterbauelement nach Anspruch 1, **dadurch gekennzeichnet**, daß beide Halbleiterkörper elektrisch gegeneinander isoliert sind.

3. Halbleiterbauelement nach Anspruch 1, **dadurch gekennzeichnet**, daß der Halbleiterschalter ein lateral aufgebauter Thyristor ist.

4. Halbleiterbauelement nach Anspruch 1, **dadurch gekennzeichnet**, daß der Thyristor mindestens zwischen einer seiner inneren Zonen (7) und der angrenzenden Außenzone (8) einen Nebenschluß (12, 14) aufweist.

5. Halbleiterbauelement nach Anspruch 4, **dadurch gekennzeichnet**, daß ein Transistor (15) vorgesehen ist, dessen Emitter-Kollektorstrecke an die inneren Zonen (6, 7) des Thyristors angeschlossen ist, daß der Basisanschluß des Transistors über die Source-Drainstrecke eines MOSFET (16) vom Anreicherungstyp mit dem Katodenanschluß (K) des Thyristors verbunden ist und daß der Gateanschluß des genannten MOSFET (16) einerseits über einen Kondensator (17) mit der anodenseitigen Innenzone (6) des Thyristors und andererseits über eine Stromquelle (18) mit dem Katodenanschluß des Thyristors verbunden ist.

6. Halbleiterbauelement nach Anspruch 1 oder 2, **dadurch gekennzeichnet**, daß der Halbleiterschalter ein Bipolartransistor ist.

7. Halbleiterbauelement nach einem der Ansprüche 1 bis 6, **dadurch gekennzeichnet**, daß die Durchlaßspannung des Halbleiterschalters kleiner als die Einsatzspannung des MOSFET (1) ist.

**Claims**

1. Semiconductor component, including a MOSFET having a semiconductor body with two main surfaces as well as a gate electrode and a source electrode, characterized by the features:
   a) the semiconductor body of a semiconductor switch (5) with p-n junction is fastened on one of the main surfaces of the semiconductor body (1) of the MOSFET, which semiconductor switch turns on when a predetermined temperature of its p-n junction is reached,
   b) the two semiconductor bodies (1, 5) are connected together thermally,

c) the semiconductor body of the semiconductor switch (5) has two main electrodes (10, 11),

d) the main electrodes are connected to the gate electrode (G) and to the source electrode (S), respectively.

2. Semiconductor component according to Claim 1, characterized in that the two semiconductor bodies are electrically insulated from each other.

3. Semiconductor component according to Claim 1, characterized in that the semiconductor switch is a lateral thyristor.

4. Semiconductor component according to Claim 1, characterized in that the thyristor has at least one shunt (12, 14) between one of its inner zones (7) and the contiguous outer zone (8).

5. Semiconductor component according to Claim 4, characterized in that a transistor (15) is provided whose emitter-collector path is connected to the inner zones (6, 7) of the thyristor, in that the base terminal of the transistor is connected via the source-drain path of a MOSFET (16) of the enhancement type to the cathode terminal (K) of the thyristor, and in that the gate terminal of said MOSFET (16) is connected on the one hand via a capacitor (17) to the anode-side inner zone (6) of the thyristor, and on the other hand via a current source (18) to the cathode terminal of the thyristor.

6. Semiconductor component according to Claim 1 or 2, characterized in that the semiconductor switch is a bipolar transistor.

7. Semiconductor component according to one of Claims 1 to 6, characterized in that the on-state voltage of the semiconductor switch is lower than the threshold voltage of the MOSFET (1).

**Revendications**

1. Composant à semiconducteurs, comportant un MOSFET qui présente un corps semiconducteur avec deux surfaces principales ainsi qu'une électrode de grille et une électrode de source, caractérisé par les particularités suivantes:

a) sur l'une des surfaces principales du corps semiconducteur (1) du MOSFET est fixé le corps semiconducteur d'un interrupteur à semiconducteurs (5) à jonction p-n, qui est fermé lorsque sa jonction p-n atteint une certaine température,

b) les deux semiconducteurs (1, 5) sont reliés thermiquement entre eux,

c) le corps semiconducteur de l'interrupteur à semiconducteurs (5) possède deux électrodes principales (10, 11),

d) les électrodes principales sont reliées à l'électrode de grille (G) ou à l'électrode de source (S).

2. Composant à semiconducteurs selon la revendication 1, caractérisé par le fait que les deux corps semiconducteurs sont isolés électriquement l'un par rapport à l'autre.

3. Composant à semiconducteurs selon la revendication 1, caractérisé par le fait que l'interrupteur à semiconducteurs est constitué par un thyristor à constitution latérale.

4. Composant à semiconducteurs selon la revendication 1, caractérisé par le fait que le thyristor comporte au moins entre l'une de ses zones intérieures (7) et la zone extérieure voisine (8), un shunt (12, 14).

5. Composant à semiconducteurs selon la revendication 4, caractérisé par le fait qu'il est prévu un transistor (5) dont le circuit émetteur-collecteur est relié aux zones intérieures (6, 7) du thyristor, que la borne de base du transistor est reliée, par l'intermédiaire du circuit source-drain d'un MOSFET (16) du type à enrichissement, avec la borne de cathode (K) du thyristor, et que la borne de grille dudit MOSFET (16) est reliée, d'une part, par l'intermédiaire d'un condensateur (17), avec la zone intérieure (6), du côté de l'anode, du thyristor, et, d'autre part, par l'intermédiaire d'une source de courant (18), avec la borne de cathode du thyristor.

6. Composant à semiconducteurs selon la revendication 1 ou 2, caractérisé par le fait que l'interrupteur à semiconducteurs est constitué par un transistor bipolaire.

7. Composant à semiconducteurs selon l'une des revendications 1 à 6, caractérisé par le fait que la tension à l'état passant de l'interrupteur à semiconducteurs est inférieure à la tension de blocage du MOSFET (1).

# FIG 1

# FIG 2